# EUROPEAN PATENT APPLICATION

(11) **EP 4 811 037 A1**
(43) Date of publication of application: **23.09.2026**
(21) Application number: 25164462.1
(22) Date of filing: 18.03.2025
(51) Int. Cl.: G03F 7/00

(54) **POSITION CONTROL METHOD FOR A STAGE, STAGE, AND LITHOGRAPHIC APPARATUS INCLUDING THE STAGE**

(71) Applicant: ASML Netherlands B.V., 5500 AH Veldhoven (NL)
(72) Inventor: KUNST, Ronald, Casper, 5500 AH Veldhoven (NL); VAN DEN BULK, John, David, Johannes, Maria, 5500 AH Veldhoven (NL); MICHIELSEN, Joris, 5500 AH Veldhoven (NL)
(74) Representative: ASML Netherlands B.V.

(57) **Abstract**

The present disclosure provides a position control method for a stage comprising a long-stroke module and a short-stroke module, the method comprising: providing a short-stroke trajectory setpoint; determining a long-stroke feedforward force; applying a first filter (N) to the long-stroke feedforward force; determining a short-stroke feedforward force; applying the first filter (N) to the short-stroke feedforward force; and determining a feedforward position correction by applying a position correction filter (Q) to the short-stroke trajectory setpoint.

## Description

### FIELD

The present invention relates to a position control method for a stage, to the stage, and to a lithographic apparatus comprising the stage. The stage herein may be a substrate stage, comprising one or more movable substrate tables. The substrate herein may be a wafer or other type of substrate suitable for lithographic processing. The disclosure also relates to a lithographic apparatus including the stage. The stage can operate using the position control method.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

In an everlasting effort to speed up production, substrate handling is streamlined into utmost detail. Typically, a wafer stage of a lithography apparatus has at least two substrate tables. A first substrate table may allow to perform preparatory measurements at the measure side, while a second substrate table enables exposure of another substrate in parallel at the exposure side. Typically, a substrate table comprises at least two parts, which can move across a flat surface. The two parts include a first module, which may be referred to as a long-stroke module, which allows relatively coarse and longer distance movements across said surface. A second module, which may be referred to as a short-stroke module, can be arranged on the long stroke module. The substrate can be arranged on top of the short stroke module, which allows fine tuning of the position of the substrate.

During operation of the lithographic apparatus, the short stroke modules are controlled such that the wafer on top of it is in focus with respect to patterning radiation and is at the correct position at a certain time. Typical control schemes herein are programmed such that the short stroke module is the master, so its position and movement are within a certain specification and tolerance. The long stroke module typically follows the movement of the short stroke module.

However, with increasing speed, problems may arise or intensify. For instance, exported forces of accelerating wafer stage parts, in particular the relatively heavy long stroke and short stroke modules accelerating at relatively high acceleration levels, may induce shocks and vibrations. Despite significant efforts to prevent, dampen or remove vibrations and to prevent vibrations - if they occur - from propagating to other parts of the machine, above some levels of accelerations it is virtually inevitable to induce standing waves - i.e. to trigger eigenfrequencies - somewhere in the machine or the direct environment of the wafer stage. Especially at higher frequencies, despite preventative measures, still significant forces are exported towards other parts of the machine, such as the projection optics, sensor frame, metrology frame, wafer handler(s) and/or reticle or mask stage. For instance, when eigenfrequencies of the wafer stage coincide with eigenfrequencies of other parts of the machine, such as the base frame or the metrology frame, at least at or near said eigenfrequencies vibrations and related performance issues may occur. For instance, eigenfrequencies may be in the 100 to 200 Hz range.

In conventional systems, it has been proposed to reduce exported forces around certain triggered eigenfrequencies, for instance 150 Hz, by choosing a constant jerk over acceleration (j/a) ratio of said eigenfrequency. Alternatively, an operator can select a constant acceleration over velocity (a/v) ratio of half the triggered eigenfrequency (for instance 75 Hz, for an exemplary eigenfrequency of 150 Hz) in the setpoint generator. Both measures ensure that the wafer stage setpoint hardly excites frequencies around the respective eigenfrequency, by significantly reducing the energy content at or near the particular eigenfrequency. As such, reducing the frequency content in the input by setpoint shaping is effective.

However, disadvantages of restricting the setpoint generator with a certain j/a or a/v ratio are threefold. First, it typically reduces throughput. Changing the scan or step velocity v or acceleration a directly negatively impacts throughput. Also, the flexibility is limited. A constant ratio of j/a or a/v can only prevent excitation of a single eigenfrequency. Finally, extra constraints introduce unwanted limitations. For instance, during calibration and diagnostic tests, the setpoint constraints can restrict the use of the full hardware potential.

The present disclosure aims to provide a system and method to mitigate vibrations due to eigenfrequencies.

### SUMMARY

The disclosure provides a position control method for a stage comprising a long-stroke module and a short-stroke module, the method comprising:
providing a short-stroke trajectory setpoint;
determining a long-stroke feedforward force;
applying a first filter (N) to the long-stroke feedforward force;
determining a short-stroke feedforward force;
applying the first filter (N) to the short-stroke feedforward force; and
determining a feedforward position correction by applying a position correction filter (Q) to the short-stroke trajectory setpoint.

In an embodiment, the long-stroke module and the short-stroke module are comprised in a cascaded assembly wherein the short-stroke module is displaced by the long-stroke module.

In an embodiment, the position correction filter Q comprises a filter function which is complementary to the first filter N. Herein, Q = (1-N).

In an embodiment, the method comprises the step of determining a difference between a first position of the long stroke module and a second position of the short stroke module, and

feeding back the determined difference to a first control module for controlling movement of the long stroke module.

In an embodiment, the step of determining the difference includes determining the difference between positions in a first direction (x), and determining the difference in at least one other direction (y).

In an embodiment, the first filter may be selected from the group comprised of: a notch filter, a low-pass filter, a band filter. The first filter is not limited to this group, but can comprise any filter or an combination of filter functions. The first filter function can be tuned to the particular eigenfrequencies which may be triggered in a particular apparatus or in the environment wherein the stage operates.

In an embodiment, the first filter targets at least one predetermined eigenfrequency of an environment of the stage.

In an embodiment, the environment of the stage may include one or more of the stage, a lithographic apparatus, a substrate handler, a base frame, a metrology frame, measurement equipment, a projection system, and an illumination system.

In an embodiment, the at least one eigenfrequency is in the range of about 50 Hz to 1 kHz, for instance about 100 Hz to 200 Hz.

In an embodiment, the method includes the step of providing a feedforward force for the short-stroke module.

According to another aspect, the disclosure provides a lithographic apparatus, the apparatus comprising:
stage system for supporting a substrate having a thickness within a nominal range, the stage system comprising:
a base surface;
a long stroke module movably arranged on the base surface;
a short stroke module for supporting the substrate and movably arranged on the long stroke module; and
a control system adapted to
provide a short-stroke trajectory setpoint;
determine a long-stroke feedforward force;
apply a first filter (N) to the long-stroke feedforward force;
determine a short-stroke feedforward force;
apply the first filter (N) to the short-stroke feedforward force; and
determine a feedforward position correction by applying a position correction filter (Q) to the short-stroke trajectory setpoint.

According to another embodiment, the disclosure provides a stage comprising a long-stroke module and a short-stroke module, comprising:
a control system adapted to provide a short-stroke trajectory setpoint;
determine a long-stroke feedforward force;
apply a first filter (N) to the long-stroke feedforward force;
determine a short-stroke feedforward force;
apply the first filter (N) to the short-stroke feedforward force; and
determine a feedforward position correction by applying a position correction filter (Q) to the short-stroke trajectory setpoint.

In an embodiment, the long-stroke module and the short-stroke module are comprised in a cascaded assembly wherein the short-stroke module is adapted to be displaced by the long-stroke module.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a top view of an exemplary substrate stage of a lithographic apparatus;
- Figure 3 depicts a side view of an exemplary substrate stage of a lithographic apparatus;
- Figure 4 depicts a diagrammatic overview of an embodiment of a control system according to the present disclosure;
- Figure 5A depicts an exemplary amplitude [dB] response versus frequency of a filter suitable for a control system of the present disclosure; and
- Figure 5B depicts an exemplary phase [deg] response versus frequency of a filter suitable for a control system of the present disclosure.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

The term "overlay error" as used herein refers to horizontal placement error between respective layers of a lithographic process. Said horizontal error may typically impact the quality of a chip. One key task of a lithography apparatus is the ability to image dense lines and spaces from the mask to the wafer. Here, the critical dimension (the width of a line), the pitch (the distance between lines) and the straightness of each of the lines are important, as well as overlay error.

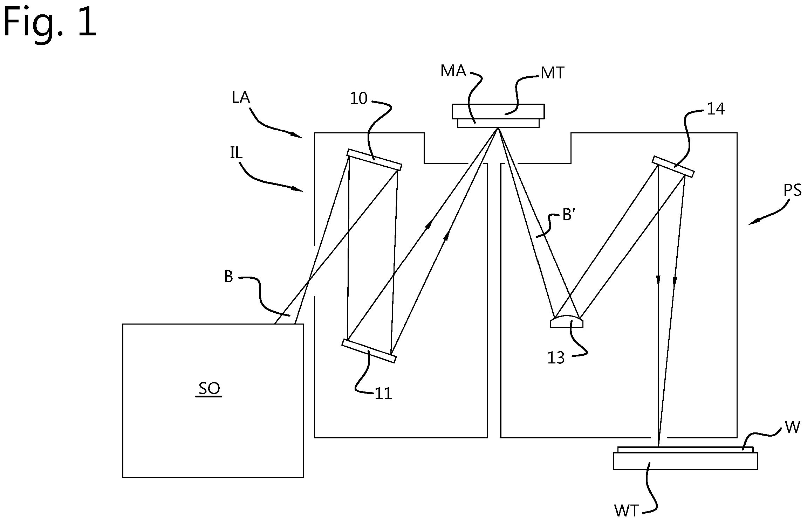

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

As depicted in Figure 1, the lithographic apparatus is of a reflective type (e.g. employing a reflective mask). Alternatively, the apparatus may be of a transmissive type (e.g. employing transmissive optical elements and a transmissive mask).

The lithographic apparatus LA may be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

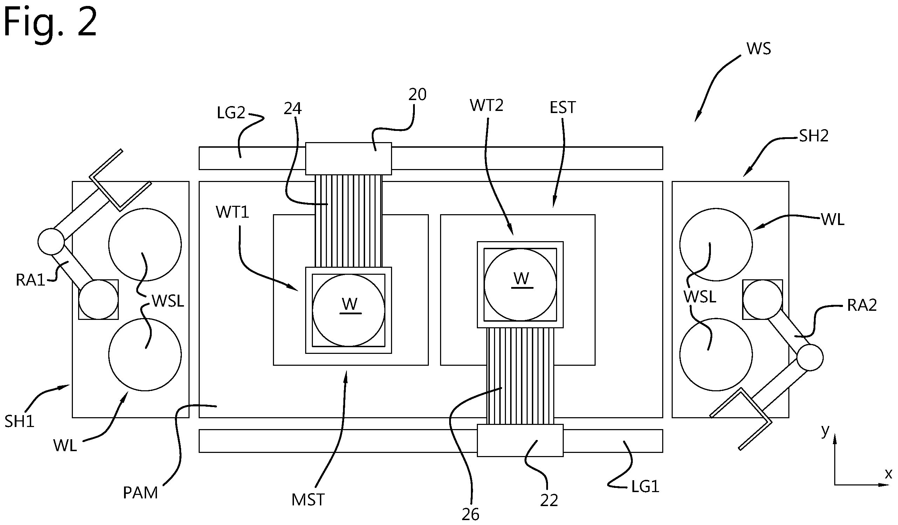

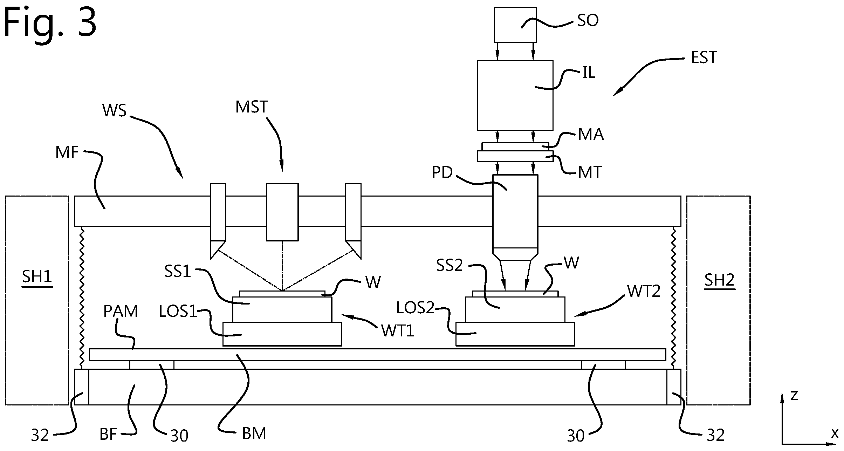

Figures 2 and 3 show an exemplary overview of a substrate stage WS. The substrate stage comprises a base frame BF. The base frame basically is a frame providing a reference position. The reference position is substantially fixed with respect to the environment.

The substrate stage may comprise one, two or more substrate tables WT1, WT2. Each substrate table is typically provided with a corresponding positioning module. In the field of lithography, the positioning modules LOS1, LOS2 may also be referred to as a "long stroke module". The substrate tables WT1, WT2 typically also comprise a corresponding short stroke module SS1, SS2.

As shown in Fig. 2, one or more guide rails LG1, LG2 may be provided at or near, for instance adjacent to, a planar surface PAM. Each positioning module or long stroke module LOS1, LOS2 of a respective substate table WT1, WT2 may be connected to one of the guide rails via a moveable coupling 20, 22. The coupling 20, 22 may allow, for instance, linear movement along a respective guide rail. The respective long stroke module LOS1, LOS2 can be connected to the respective coupling 20, 22 via a linearly extendable connection 24, 26. Said linearly extendable connection may comprise, for instance, a flexible cable slab. The cable slab may comprise one or more cables, for instance to provide power, cooling, and data to and from the respective positioning module. The positioning modules or long stroke modules LOS1, LOS2 are adapted to allow planar movement of the respective modules with respect to the planar surface PAM. The short stroke modules SS1, SS2 may comprise drive means for moving the respective modules with respect to the corresponding long stroke module.

The drive means may be based on, for instance, a mechanical direct drive, or electromagnetic drive means. An electromagnetic drive system may comprise, for instance, electromagnets arranged in the balance mass BM and/or the long stroke modules LOS1, LOS2.

For instance, a planar motor concept may be implemented to realize horizonal accelerations of the respective long stroke modules. A planar motor may include a magnet array, forming a so called Magnet Plate. The magnet array can be arranged, for instance, on top of the balance mass BM or may be integral to the balance mass BM. The magnet array herein may contribute to the total mass of the balance mass BM. Alternatively, a magnet array formed by (superconductive) magnetic coils may be included in the balance mass. Corresponding magnetic coils of the planar motor concept may be comprised in or on the bottom surface of a respective long stroke module LOS1, LOS2.

The respective short stroke modules SS1, SS2 may likewise be provided with drive means, allowing accurate positioning of the short stroke module with respect to the long stroke module. Typically, said drive means include electromagnetic drivers.

One or more substrate handlers SH1, SH2 may be arranged adjacent to the substrate stage WS. The respective substrate handler typically comprises one or more storage positions WSL for holding a stack of substrates. The stack of substrates may also be referred to as a substrate lot WL. A substrate lot herein typically comprises a number of substrates each intended for a specific step in a lithographic process. Each substrate handler may be provided with one or more robot arms RA1, RA2 for transferring substrates W from one of the storage locations WSL to one of the substrate tables, or vice versa.

The substrate stage may be provided with an exposure station EST. The exposure station may refer to a location or area where a substrate W on one of the substrate tables can be exposed to radiation for patterning resist on said substrate. See also Figure 1 and the related description above. The substrate stage may be provided with another location or area intended for executing certain measurements. Said location or area may be referred to as measurement station MST. The measurements herein may include, but are not limited to, pre-expose measurements - such as surface, height, and topography mapping, and accurate positioning- and post-expose measurements such as control of exposed patterns. The measurement station MST, see Fig. 3, may include one or more sensors and related control equipment intended for the measurements as referenced. However, said sensors may also be included in or on the respective substrate tables or at any other viable position.

The respective short stroke modules SS1, SS2 may typically be able to move with respect to the corresponding positioning modules LOS1, LOS2. Herein, the long stroke modules LOS1, LOS2 may typically enable relatively fast movement over relatively longer distances. The short stroke modules SS1, SS2 may enable very accurate movements yet over a (much) shorter distance.

Please note that Figures 2 and 3 serve as a generic reference. Many other setups for a substrate stage WS are conceivable. Basically, the figures exemplify how a single substrate stage may comprise multiple substrate tables which can move individually with respect to each other and be involved in different steps of the lithographic process in parallel.

Relatively large horizontal forces due to repeated acceleration and deceleration of the respective long stroke modules LOS1, LOS2 and the corresponding short stroke modules SS1, SS2 can at least partially be absorbed using a balance mass principle. Herein, a balance mass unit BM is arranged between the substrate table WT and the base frame BF. The balance mass BM may typically have a substantially flat and planar top surface PAM.

The balance mass BM may typically be connected to the base frame BF via one or more bearings 30 (Fig. 3). The bearings 30 may be air bearings. The air bearings may be bellow like structures. The bearings may be provided in or on a bearing frame. The bearing frame may be connected to the base frame BF via support legs. The bearings may be air bearings, and the bearing frame may be an air bearing frame. An actuator or comparable controller may be arranged between a horizontal edge of the balance mass BM and the base frame BF. The actuator or comparable controller element may dampen or obviate horizontal drift of the balance mass with respect to the base frame.

The substrate tables are moveable with respect to the planar surface PAM. Relatively large horizontal forces originating from accelerations of respective Long Stroke and Short Stroke modules are absorbed with the balance mass BM in planar direction, i.e. X- and Y-direction with respect to the surface PAM. However, these horizontal forces typically lead to Rx, Ry and Rz torques on the base frame BF (which are typically not fully compensated by the balance mass BM). To counteract said torque, the base frame BF may be provided with one or more torque compensators 32 (Fig. 3). The torque compensators 32 as connected to the base frame BF may provide forces or torques in vertical direction, thereby compensating rotations around the horizontal directions (Rx, Ry). To counteract rotations around the vertical direction (Rz), including torques induced by moving the substrate tables, the Rz angle is typically kept close to zero using a low bandwidth controller (such as 1 to 10 Hz) by exerting low frequent forces onto the base frame using motors (not shown).

Thus, at least part of the forces and torques originating from movements and accelerations of respective substrate tables can be compensated for by the balance mass BM and the torque compensators.

Nevertheless, in particular at higher frequencies, for instance exceeding 50 Hz or 100 Hz, relatively significant forces can still be exported towards other parts of the lithographic apparatus LA, such as the projection system PS, sensor frame, metrology frame MF, substrate handlers SH1, SH2, or mask or reticle handler. For instance when eigenfrequencies of the substrate stage coincide with eigenfrequencies of the base frame BF or the metrology frame MF, performance may be negatively impacted due to vibrations caused by resonances at respective eigenfrequencies.

For instance, eigenfrequency related performance issues may occur when triggering eigenfrequencies of the substrate stage WS, the air mounts 30 (standing waves in the air tanks), metrology frame MF (clapping mode) and in vibration isolation systems (resonances). Examples of eigenfrequencies may include, but are not limited to, one or more of about 100 Hz, 125 Hz, 150 Hz, 200 Hz, 250 Hz, 300 Hz, 350 Hz, 500 Hz, 750 Hz, and 1 kHz. The latter are exemplary only. Eigenfrequencies may differ depending on the particular environment and lithographic apparatus wherein a particular substrate stage is included.

As described above, the long-stroke module LOS and the short-stroke module SS together constitute a cascaded assembly. Herein, the short-stroke module is displaced by the long-stroke module. Ultimately however, the short stroke module SS will have to be correctly positioned with respect to the impending patterned beam B' of radiation (see Fig. 1).

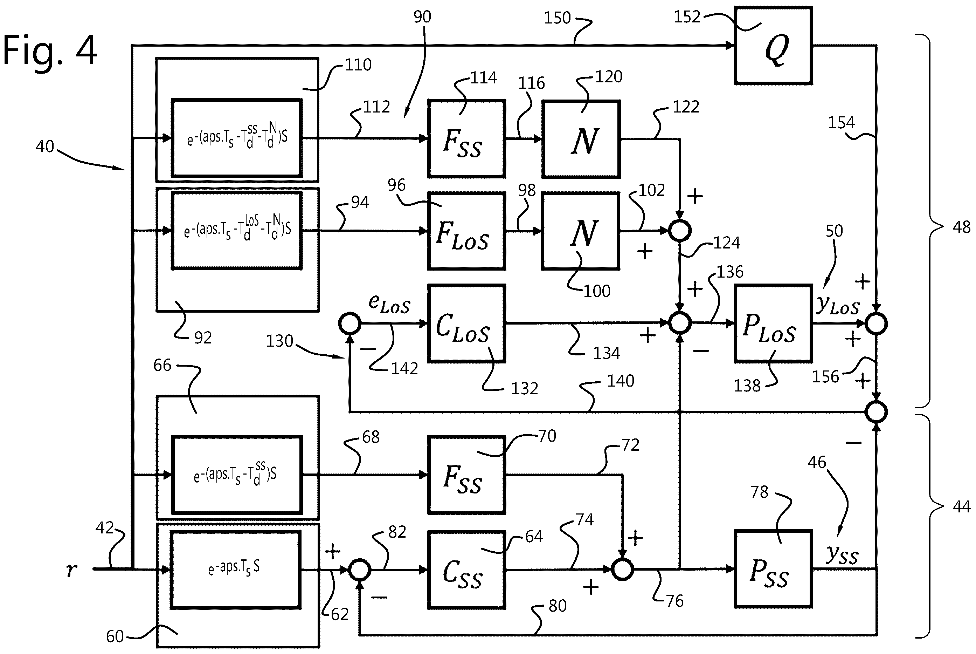

Generally referring to Figure 4, a control system 40 for positioning an assembly of long stroke module LOS and short stroke module SS may comprise an input 42 for receiving a setpoint r. The setpoint r may comprise an indication of one of more of position, velocity, acceleration and time. The setpoint will typically be time dependent. Herein, the position and acceleration varies over time to allow the substrate table and its components to follow a predetermined trajectory.

Said setpoint r may typically be intended for the short stroke module SS, while the long stroke module LOS will have to provide at least part of the movement and acceleration, as explained herein above. Herein, movement of the long stroke module will inherently also imply movement of the short stroke module. Movement of the short stroke module with respect to the long stroke module will, however, typically require a suitable force provided by the long stroke module, to counteract inertia.

For sake of simplicity and to keep the diagram of Fig. 4 comprehensible, the control system 40 in Fig. 4 is limited to a single linear direction only, such as the y-direction. Please note however that the control system 40 can comprise similar control schemes for other degrees of freedom, such as a linear movement in the x-direction, which is typically perpendicular to the y-direction mentioned before.

The control system 40 comprises a first section 44 for providing a first output 46 and a second section 48 for providing a second output 50. The first output 46 provides a first position control signal yₛₛ for the short stroke module. The second output 50 provides a second position control signal yₗₒₛ for the long stroke module.

Typically, in a lithographic apparatus LA and/or in a substrate stage WS, the short stroke module determines the exact position, whereas the long stroke module LOS follows said position of the short stroke module. For instance, the short stroke module SS may have a range of motion on the order of +/- 500 µm with respect to the long stroke module. Upon movement, the long stroke module follows movement of the corresponding short stroke module with a short delay and with a positioning error within a range of, for instance, about +/- 5 to 10 µm (or at least, well within the available range of motion).

Both modules comprise a motor system to drive the respective module. The long stroke module can move with respect to the planar surface PAM (Fig. 2 and 3). The short stroke module can move with respect to the long stroke module. If the short stroke module moves, the long stroke module typically needs to be provided with a control signal to provide a force in the opposite direction, to counteract the momentum of the short stroke module.

Optionally, the control system 40 may comprise units to delay the output with respect to the input. Said delay may, for instance, be a set number of samples. Said set number may depend on the filtering, and the resulting delay caused by filtering, as applied in the control system 40 and as described herein below. The number of samples for the delay may be selected as a difference between the position and acceleration setpoints. The latter enables to shift the setpoint acceleration (and thus the feedforward) forward in time compared to the setpoint position.

In an embodiment, the first section 44 may comprise a first delay unit 60 to provide a first delayed position signal 62. The first delay signal 62 may be compared to the first output 46. The difference of both signals may be provided to a first controller 64 (Cₛₛ). The first delay unit 60 may provide a time delay to the position information included in the setpoint r as provided. The first controller 64 may provide a first position correction signal 74. The output signal 74 represents a force that needs to be generated by the drive of the short stroke module.

A second delay unit 66 may provide a second delayed signal 68 to a first force generator 70 (Fₛₛ). The first force generator 70 provides a first force output 72. The second delay unit 66 and the first force generator 70 can be considered a first feed forward loop of the control system 40. The first force output 72 of the force generator 70 (Fss) also represents a force to be generated by the drive of the short stroke module. The first force output 72 may be combined with the first position correction signal 74, resulting in a first corrected force signal 76. Said first corrected force signal 76 may be provided to first plant section 78 (Pₛₛ). The first plant section 78 represents, for instance, mechanical behavior of the short stroke module, including for instance inertia and friction due to weight and connected cable slabs (see Fig. 2 for an example). The first plant section 78 basically provides a model of the short stroke module, allowing to provide a more accurate position control signal for the short stroke module.

Output of the first plant section 78 is the first output signal 46. Said first output signal 46 represents the Y-position yₛₛ of the short stroke module SS.

The first section 44 typically comprises a first feedback loop 80. The first feedback loop 80 provides the first output signal 46. A difference of the first output signal 46 and the first delayed position signal 62 is provided to the first controller or short stroke controller 64 (Css). Herein, a first difference signal 82 is provided to the first controller 64. Said first difference signal 82 is the difference between the first delay signal 62, representing the time-delayed setpoint r, and the first output signal 46, representing the Y-position yₛₛ of the short stroke module. By combining the latter with the first force output 72 of the first feed forward loop, the position control of the short stroke module can be corrected within a set accuracy and time frame.

The second section 48 may comprise a second feed forward loop 90. The second feed forward loop may comprise two loops. One loop herein is directed to positioning the long stroke module. A second loop may be directed to counteracting force acting on the long stroke module due to movement of the corresponding short stroke module.

The second feed forward loop 90 may comprise a third delay unit 92 for providing a third delayed signal 94. The third delayed signal 94 can be provided to a second force generator 96 (F_{LoS}). The second force generator provides a second force output 98. The second force output 98 is basically intended for moving the respective long stroke unit LOS. It thus represents a force that needs to be generated by the drive or drive system of the long stroke module.

According to an embodiment of the disclosure, the second force output 98 is provided to a filter 100 (N). The filter 100 provides a filtered second force output 102.

The second feed forward loop 90 may comprise a fourth delay unit 110. The fourth delay unit 110 may provide a fourth delay signal 112 to a third force generator 114 (Fₛₛ). The third force generator 114 provides a third force signal 116. The third force signal 116 is intended to be supplied to the long stroke module, for counteracting force on the long stroke module due to movement of the short stroke module, as explained herein above. It thus also represents a force that needs to be generated by the drive or drive system of the long stroke module. Herein, typically, the third force signal 116 will be substantially similar but opposite in direction to the first force signal 72.

In an embodiment of the present disclosure, the third force signal 116 is provided to a second filter 120 (N). The second filter 120 provides a filtered third force output 122. In an embodiment, the second filter 120 is substantially similar to the first filter 100.

The filtered third force output 122 may be added to the second filtered force output 102 to provide a combined filtered force signal 124.

The second section 48 for driving the long stroke module LOS may comprise a second feedback loop 130. Herein, the second feedback loop 130 may include a second controller 132. The second controller 132 provides a second position correction signal 134, the second position correction signal representing a correction force to be generated by the long stroke module.

The second position correction signal 134 can be added to the combined force signal 124. In an embodiment, the first corrected force signal 76 may be subtracted from the combined force signal 124.

Herein, in a practical embodiment, a second corrected force signal 136, combining the combined force signal 124 and the second position correction signal 134, is provided to second plant section 138 (P_{LoS}). The second plant section 138 represents, for instance, mechanical behavior of the long stroke module, including for instance inertia and friction due to weight and connected cable slabs (see Fig. 2 for an example). The second plant section basically provides a model of the long stroke module, allowing to provide a more accurate position control signal for the long stroke module.

Output of the second plant section 138 is the second output signal 50. Said second output signal 50 represents the Y-position Y_{LoS} of the long stroke module LoS.

A feedback signal 140 as provided as input to the second feedback loop 130 may comprise a difference between the second output 50 (for controlling position of the long stroke module) and the first output 46 (for controlling position of the short stroke module). Said feedback signal represents an indication of a second position difference e_{LoS} of the long stroke module. Herein, e_{LoS} is not a position error of the long stroke module LoS relative to the reference r, but is merely a position difference between the position of the long stroke module Y_{LoS} and the position of the short stroke module Y_{SS}. Said position difference 142 is provided as input to the second controller 132 (C_{LoS}). Again, please note that the example herein is limited to the y-direction. The control system 40 may include additional and comparable components for other degrees of freedom, such as the x-direction.

In an embodiment, the control system 40 includes an additional correction loop 150. Herein, the setpoint 42 is provided to a correction filter 152. The correction filter may, in an embodiment, substantially be complementary to the first filter 100. For instance, if the filter function of the first filter 100 is represented by N, a correction function Q of the correction filter 152 can be represented by: Q = 1-N.

In an embodiment, the correction filter 152 may also include an additional function, such as an integrator. As a practical example, the correction filter 152 may include an integrator represented by $\frac{1}{{s}^{2} + 2 {ξω}_{p} s + {ω}_{p}^{2}}$. The latter may be regarded as a tame double integrator.

A filtered output 154 of the correction filter 152 may be added to the second output 50. A sum signal 156 of the second output 50 and the filtered output 154 can be provided to the second feedback loop 130. Herein, the second output 46 may be subtracted from the sum signal 156 to provide the feedback signal 140.

In the control system 40, the forces 116 and 98 are both forces that will be provided to and used to activate the drive system of the long-stroke module LOS. The force 114 (Fss) to which the filter 120 (N) is applied is, in fact, the reaction force of the force 72, determined by the force generator 70 (Fss) applied to activate the drive system of the short-stroke module. Please note that in the embodiment of Figure 4, the force 72 in the short-stroke motor control loop 44 lacks the filter function N as included in the long stroke motor control loop 48.

The filter function N may include any suitable filter. The filter function N may include one or more of a notch filter, a band filter, a low-pass filter, or a combination thereof. The filter function N may include multiple notch filter functions in combination.

In a practical embodiment, the filter function N aims to filter eigenfrequencies which may be triggered in the environment of the substrate stage WS, as outlined in the introduction. For instance, if a particular substrate stage will be employed in an environment wherein one or more particular eigenfrequencies may be triggered, the filter function N may include one or more notch filters, each targeting one of said eigenfrequencies. If the substrate stage will be employed in an environment wherein multiple eigenfrequencies or varying eigenfrequencies may be triggered, each above a certain threshold frequency, the filter function N may include a low-pass filter with a cutoff frequency at or near said threshold frequency. If the substrate stage will be employed in an environment wherein one or more eigenfrequencies may be triggered, within a certain range or frequency band, the filter function N may include a band filter targeting said frequency range (i.e. substantially blocking said frequency range while allowing other frequencies to pass).

In a practical embodiment, the filter function N includes one or more notch filters, with each notch filter targeting a frequency in the range of 50 to 1 kHz. The filter function N may include a notch filter targeting, for instance, one or more of about 100 Hz, 110 Hz, 120 Hz, 130 Hz, 140 Hz, 150 Hz, 160 Hz, 170 Hz, 180 Hz, 190 Hz, 200 Hz, 210 Hz, 220 Hz, 230 Hz, 240 Hz, 250 Hz, 260 Hz, 270 Hz, 280 Hz, 290 Hz, 300 Hz, 310 Hz, 320 Hz, 330 Hz, 340 Hz, 350 Hz, 360 Hz, 370 Hz, 380 Hz, 390 Hz, 400 Hz.

In a practical embodiment, the filter function N includes a low-pass filter, having a cut-off frequency in the range of 50 to 1 kHz. The cut-off frequency may be, for instance, about 50Hz, 60 Hz, 70 Hz, 80 Hz, 90 Hz, 100 Hz, 110 Hz, 120 Hz, 130 Hz, 140 Hz, 150 Hz, 160 Hz, 170 Hz, 180 Hz, 190 Hz, 200 Hz, 210 Hz, 220 Hz, 230 Hz, 240 Hz, 250 Hz, 260 Hz, 270 Hz, 280 Hz, 290 Hz, 300 Hz, 310 Hz, 320 Hz, 330 Hz, 340 Hz, 350 Hz, 360 Hz, 370 Hz, 380 Hz, 390 Hz, 400 Hz.

In a practical embodiment, the filter function N includes a band filter function targeting a frequency range of, for instance, one or more of about 50Hz to 1 kHz, 50 Hz to 300 Hz, 100 Hz to 200 Hz, 100 Hz to 500 Hz, 110 Hz to 1 kHz, 150 Hz to 600 Hz.

In the control system 40 according to the present disclosure, the filter N is applied in the second section 48 for driving the long stroke module LOS to both the short stroke force 116, determined by the force generator 114 (Fss), and to the long stroke force 98, determined by the second force generator 96 (F_{LoS}). Both these forces are forces that need to be made by the long-stroke motor. The short stroke force 116 (Fₛₛ) to which the filter 120 (filter function N) is applied is in fact the reaction force of the short stroke force 72 that applies to the short-stroke motor. Herein, the short stroke force 72 in the short-stroke motor control loop 44, i.e. the feedforward force for the short-stroke motor, is not filtered by filter function N.

A method of operating a stage comprising a long-stroke module and a short-stroke module may comprise the following steps. In a first step the setpoint r is provided. Said setpoint is typically a short-stroke trajectory setpoint. The method includes a step of determining the long-stroke feedforward force 98. Next, a first filter 100 (N) is applied to the long-stroke feedforward force 98 as generated by the force generator 96 (F_{LoS}).

The method includes the step of determining a short-stroke feedforward force 116. As explained above, said short stroke feedforward force 116 may substantially correlate to an opposite of the short stroke feedforward force 72 applied in the short stroke control section 44. Next, the method applies the first filter (N) to the short-stroke feedforward force 116.

In an improved embodiment, the method includes determining a feedforward position correction. The latter may include applying a position correction filter 152 (Q) to the short-stroke trajectory setpoint r.

The position correction Q may, in a practical embodiment, provide a complementary filter function to the first filter function, i.e. Q = (1 - N).

Herein, the long-stroke module LOS and the short-stroke module SS are comprised in a cascaded assembly wherein the short-stroke module is displaced by the long-stroke module.

The system and method as disclosed herein enable the reduction of forces exported to the environment from the substrate stage WS to the base frame BF. The system and method herein allow flexibility without throughput consequences. This can be obtained by filtering the long stroke feedforward forces, such as forces 114 and 96 in Fig. 4.

Wafer stage forces required to move the primary movers, such as both modules of the substrate stages, may excite dynamics in the substrate stage and in other parts of the machine, such as the base-frame, the substrate stage support frame, etc. Said forces are dominated by feedforward forces relating to the long stroke module. Referring to the control system of Figure 4, the latter relate to feed forward forces in the long stroke section 48.

For instance, long stroke module forces in either x-direction and/or y-direction may, for instance, excite torsion modes of the base frame BF or other modules. Such modes may be in the range of 100 to 200 Hz, for instance about 120 to 150 Hz. Filtering feed-forward forces relating to the long stroke section 48 of the control system with a filter N targeting frequencies relating to said excited modes, reduces excitation.

The filter N herein may include a notch filter, an MA filter or a low-pass filter. The filter N reduces excitation of dynamics in a flexible way. Multiple notch filters at various frequencies and depths can be used. The system obviates loss of throughput, see the control diagram in Figure 4 with notch filter N. Also the reaction feedforward force 114 may be filtered with N, thus minimizing the system dynamic excitation.

Using (notch) filters N in the feed-forward loop 90 of the long stroke section 48 of the control system 40 causes the long stroke module LoS to move along another trajectory than the unfiltered trajectory of the short stroke setpoint r. A difference sensor for sensing a difference between the position of the long stroke module LoS and the short stroke module SS will detect this difference. See feedback signal 140 in Figure 4.

In the embodiment of Figure 4, the LoS feedback controller 132 will react to the second position difference e_{LoS} of the long stroke module by producing forces especially around the frequency or frequencies as filtered by the filter function N. The second position difference e_{LoS} (142) may also be referred to as the LoS2SS (long stroke to short stroke) error as it is indicative for the positional difference between the long stroke module and the short stroke module. Thus, the controller 132 will try to adjust the LoS2SS error 142 to zero. Preferably, the latter is obviated since the control system 40 aims to prevent exerting forces around this notch frequency. In a practical embodiment, the LoS controller 132 may have a sensitivity of +6 dB, meaning that the controller 132 reacts with an extra amplification factor of two to controller errors 142 around said filtered frequency.

To prevent the controller 132 (C_{LoS}) from reacting to filtered frequencies, a position correction may be applied to the calculation of the LoS2SS controller error 142. Said position correction may be provided by the position correction filter 152 (see block Q in Figure 4). By adding the filtered position input 154 to the LoS position control signal 50 obscured the filtered frequencies from the LoS controller 132. Basically, the position correction filter 152 renders the LoS controller 132 blind for LoS2SS position differences around the one or more frequencies as filtered by the filter function N.

Preferably, the position correction 154 is a feedforward based on the setpoint r. The latter is preferred over directly filtering the measured LoS2SS difference 140. A filter in the LoS feedback loop 130 may significantly impact tuning of the controller 132, leading to decreased bandwidths, larger errors of the LoS2SS controller 132, and thus to deteriorated performance, for instance of the short stroke module, via dynamic links between the long stroke module LoS and the short stroke module SS. Moreover, such filter may cause mechanical range issues as a result of large LoS2SS errors 142.

Herein below a theoretical explanation of the control system and method of the disclosure is provided.

If ${P}_{ss} = \frac{1}{{m}_{ss} {s}^{2}} {e}^{- {T}_{d}^{ss} s} and {F}_{ss} = {m}_{ss} {s}^{2} then {y}_{ss} = {e}^{- aps ⋅ {T}_{s} ⋅ s} ⋅ r .$

If ${P}_{LoS} = \frac{1}{{m}_{LoS} {s}^{2}} {e}^{- {T}_{d}^{LoS} s} and {F}_{LoS} = {m}_{LoS} {s}^{2}$ then:
- ${y}_{LoS} = {P}_{LoS} \left(\begin{matrix}{NF}_{LoS} {e}^{- \left(aps⋅{T}_{s}-{T}_{d}^{LoS}-{T}_{d}^{N}\right) s} + {NF}_{SS} {e}^{- \left(aps⋅{T}_{s}-{T}_{d}^{SS}-{T}_{d}^{N}\right) s} - \\ {F}_{SS} {e}^{- \left(aps⋅{T}_{s}-{T}_{d}^{SS}\right) s}\end{matrix}\right) r .$
- ${y}_{LoS} = {P}_{LoS} \left({NF}_{LoS}{e}^{\left({T}_{d}^{LoS}+{T}_{d}^{N}\right) s}+{NF}_{SS}{e}^{\left({T}_{d}^{SS}+{T}_{d}^{N}\right) s}-{F}_{SS}{e}^{{T}_{d}^{SS} s}\right) {e}^{- aps ⋅ {T}_{s} ⋅ s} ⋅ r$
- ${y}_{LoS} = {Ne}^{- \left(aps⋅{T}_{s}-{T}_{d}^{N}\right) s} ⋅ r + {P}_{LoS} {F}_{SS} \left({Ne}^{{T}_{d}^{N} ⋅ s}-1\right) {e}^{- \left(aps⋅{T}_{s}-{T}_{d}^{SS}\right) s} ⋅ r$
- ${y}_{LoS} = {Ne}^{\left(-aps⋅{T}_{s}+{T}_{d}^{N}\right) s} ⋅ r + \frac{{m}_{SS}}{{m}_{LoS}} \left({Ne}^{{T}_{d}^{N} ⋅ s}-1\right) {e}^{\left(-aps⋅{T}_{s}-{T}_{d}^{LoS}+{T}_{d}^{SS}\right) s} ⋅ r$

In addition to the above:
- ${e}_{LoS} = {y}_{ss} - {y}_{LoS} - Q ⋅ r .$
- ${e}_{LoS} = \left({e}^{- aps ⋅ {T}_{s} ⋅ s}-{Ne}^{\left(-aps⋅{T}_{s}+{T}_{d}^{N}\right) s}-\frac{{m}_{SS}}{{m}_{LoS}}\left({Ne}^{{T}_{d}^{N} ⋅ s}-1\right){e}^{\left(-aps⋅{T}_{s}-{T}_{d}^{LoS}+{T}_{d}^{SS}\right) s}-Q\right) ⋅ r .$
- ${e}_{LoS} = \left(\left(1-{Ne}^{{T}_{d}^{N} ⋅ s}\right){e}^{- aps ⋅ {T}_{s} ⋅ s}-\frac{{m}_{SS}}{{m}_{LoS}}\left({Ne}^{{T}_{d}^{N} ⋅ s}-1\right){e}^{\left(-aps⋅{T}_{s}-{T}_{d}^{LoS}+{T}_{d}^{SS}\right) s}-Q\right) ⋅ r .$

As explained above, the error 142 in the long stroke feedback loop 130 caused by the filter N is typically compensated by the position correction loop 150. Herein, in the present invention, the positional difference e_{LoS} is partly caused by the filtering N. The filtering N is done to avoid long-stroke forces in certain frequency bands or at certain frequencies, to eliminate triggering corresponding eigenfrequencies in the system at large. Without taking measures, however, these forces may be re-introduced due to the controller actions of C_{LoS}. The correction filter Q (1-N) obviates this controller action. As a result, the positional difference (i.e. the actual positional difference Y_{LoS}-Y_{SS}) will not be corrected by the control action. As such, the present invention may cause a positional difference between long stroke module and short stroke module, which is not compensated for. Nevertheless, said positional difference is acceptable in practice due to the reciprocating motions of a substrate stage during irradiation of a substrate.

The latter may fully obviate any remaining error, rendering the error substantially zero. And referring to the formulas above: ${e}_{LoS} = 0 if Q = \left(1-{Ne}^{{T}_{d}^{N} ⋅ s}\right) {e}^{- aps ⋅ {T}_{s} ⋅ s} + \frac{{m}_{SS}}{{m}_{LoS}} \left(1-{Ne}^{{T}_{d}^{N} ⋅ s}\right) {e}^{\left(-aps⋅{T}_{s}-{T}_{d}^{LoS}+{T}_{d}^{SS}\right) s} .$

Thus, Q can be provided with a filter function: $Q = \left(1-{Ne}^{{T}_{d}^{N} ⋅ s}\right) {e}^{- aps ⋅ {T}_{s} ⋅ s} + \left(1-{Ne}^{{T}_{d}^{N} ⋅ s}\right) \frac{{m}_{SS}}{{m}_{LoS}} {e}^{\left(-aps⋅{T}_{s}-{T}_{d}^{LoS}+{T}_{d}^{SS}\right) s} .$

The control system 40 may also include one or more delays. Herein, the position of the short stroke setpoint r is equal to a reference position, yet delayed with a certain number of samples 'aps'. For instance, the delay may be 5 to 50 samples. The latter provides an opportunity to advance the feedforward force compared to the setpoint position compensating for delay in the plant sections 78, 138. Herein, 'aps' represents a delay value, typically an integer number representing a number of samples. Said delay value can compensate delay caused by filtering, due to filter N. For instance, a term such as *aps* ▪ *Tₛ* ▪ *s* means a delay of a number of 'aps' samples. These 'aps' number of samples may represent a selected difference between the position and acceleration setpoints. The delay provides the opportunity to shift the setpoint acceleration, and thus the feedforward, forward in time compared to the setpoint position.

The delay of the short stroke plant section 78 *P_{SS}* is ${T}_{d}^{SS}$*,* which may be on the order of 100 to 150 µsec. The delay of the long stroke plant section 138 *P_{LoS}* is ${T}_{d}^{LoS}$, which may be on the order of 200 to 300 µsec.

For low frequencies, a notch filter can be approximated by an amplitude 1 and a phase lag corresponding to a pure time delay ${T}_{d}^{N}$*,* which depends on the notch filter settings. Signals filtered with the notch filter *'N'* must be advanced in time with ${T}_{d}^{N}$ to minimize the difference between first and section position outputs 46 and 50 (*y_{SS}* and *y_{LoS}*)*.* For low frequencies, filter *'N'* can be substituted with ${e}^{- {T}_{d}^{N} ⋅ s}$*.* Then *y_{SS} - y_{LoS}* = 0 for all references *r* according to the equations above. Low frequencies herein may include frequencies in the range of 50 to 300 Hz.

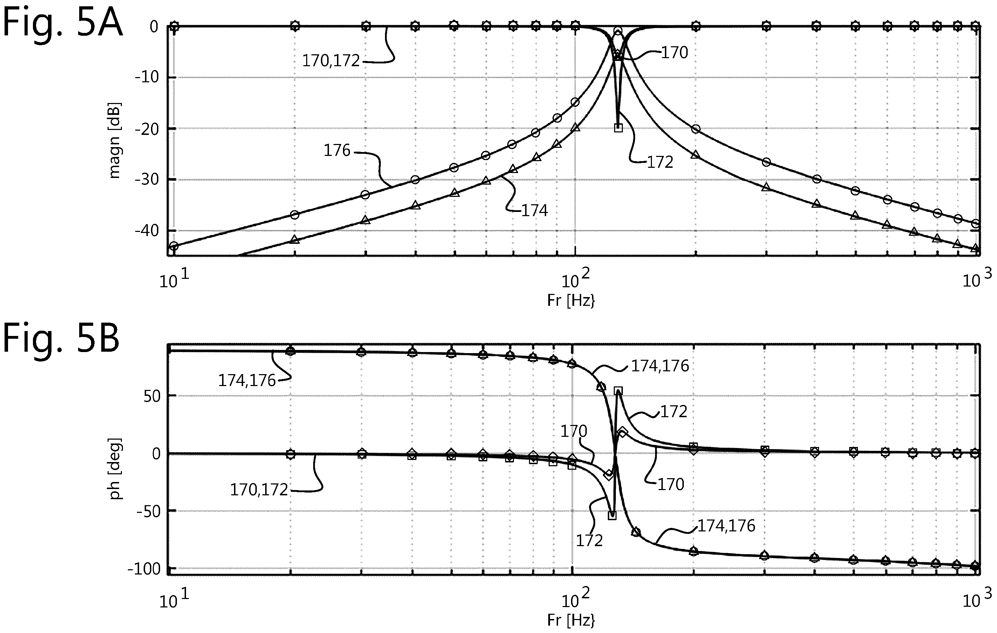

The above is exemplified in Figures 5A and 5A, which show bode plots of two exemplary notch filters (N) 170, 172 and the corresponding position correction filter (1-N) 174, 176. Herein, both exemplary notch filters 170, 172 target the same frequency, however using a different amplitude or gain factor. Figure 5A shows amplitude response on the vertical axis versus frequency on the horizontal axis. Figure 5B shows the phase response on the vertical axis version frequency on the horizontal.

The embodiments as described herein above may be equally applicable to a wide range of lithography apparatuses. For instance, the embodiments can be applied to DUV systems and EUV systems, allowing to process a wider range of (thicker) substrates.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below. For instance, features of various embodiments as described above may be combined.

## Claims

1. Position control method for a stage comprising a long-stroke module and a short-stroke module, the method comprising:
providing a short-stroke trajectory setpoint;
determining a long-stroke feedforward force;
applying a first filter (N) to the long-stroke feedforward force;
determining a short-stroke feedforward force;
applying the first filter (N) to the short-stroke feedforward force; and
determining a feedforward position correction by applying a position correction filter (Q) to the short-stroke trajectory setpoint.

2. The method of claim 1, wherein the long-stroke module and the short-stroke module are comprised in a cascaded assembly wherein the short-stroke module is displaced by the long-stroke module.

3. The method of claim 1 or 2, wherein the position correction filter (Q) comprises a filter function complementary to the first filter function (N) of the first filter, wherein Q = (1-N).

4. The method of one of the previous claims, comprising the step of determining a difference between a first position of the long stroke module and a second position of the short stroke module, and
feeding back the determined difference to a first control module for controlling movement of the long stroke module.

5. The method of claim 4, wherein the step of determining the difference includes determining the difference between positions in a first direction (x), and determining the difference in at least one other direction (y).

6. The method of one of the previous claims, wherein the first filter is selected from the group of: a notch filter, a low-pass filter, a band filter.

7. The method of one of claims 1 to 6, wherein the first filter targets at least one predetermined eigenfrequency of an environment of the stage.

8. The method of claim 7, wherein the environment of the stage may include one or more of the stage, a lithographic apparatus, a substrate handler, a base frame, a metrology frame, measurement equipment, a projection system, and an illumination system.

9. The method of claim 7 or 8, wherein the at least one eigenfrequency is in the range of about 50 Hz to 1 kHz, for instance about 100 Hz to 200 Hz.

10. The method of one of the previous claims, including the step of providing a feedforward force for the short-stroke module.

11. A lithographic apparatus, the apparatus comprising:
stage system for supporting a substrate having a thickness within a nominal range, the stage system comprising:
a base surface;
a long stroke module movably arranged on the base surface;
a short stroke module for supporting the substrate and movably arranged on the long stroke module; and
a control system adapted to
provide a short-stroke trajectory setpoint;
determine a long-stroke feedforward force;
apply a first filter (N) to the long-stroke feedforward force;
determine a short-stroke feedforward force;
apply the first filter (N) to the short-stroke feedforward force; and
determine a feedforward position correction by applying a position correction filter (Q) to the short-stroke trajectory setpoint.

12. A stage comprising a long-stroke module and a short-stroke module, comprising:
a control system adapted to provide a short-stroke trajectory setpoint;
determine a long-stroke feedforward force;
apply a first filter (N) to the long-stroke feedforward force;
determine a short-stroke feedforward force;
apply the first filter (N) to the short-stroke feedforward force; and
determine a feedforward position correction by applying a position correction filter (Q) to the short-stroke trajectory setpoint.

13. The stage of claim 12, wherein the long-stroke module and the short-stroke module are comprised in a cascaded assembly wherein the short-stroke module is adapted to be displaced by the long-stroke module.
